# EUROPEAN PATENT SPECIFICATION

(11) **EP 2 500 448 B1**
(45) Date of publication and mention of the grant of the patent: **13.11.2013**
(21) Application number: 12157102.0
(22) Date of filing: 27.02.2012
(51) Int. Cl.: C23C 14/56, C23C 14/58, C23C 14/02

(54) **Machine and method for metallization of three-dimensional objects of small sizes**
Vorrichtung und Verfahren zum Metallisieren dreidimensionaler, kleinstückiger Gegenstände
Dispositif et méthode pour la métallisation de pièces tridimensionelles de taille petite

(30) Priority: 18.03.2011 IT MI20110432
(43) Date of publication of application: 19.09.2012
(73) Proprietor: TAPEMATIC S.p.A., 20876 Ornago (Monza Brianza) (IT)
(72) Inventor: Perego, Luciano, 23087 Merate (Lecco) (IT)
(74) Representative: Vittorangeli, Lucia

(56) References cited:
- WO-A1-00/28105
- JP-A- 63 265 627

## Description

The present invention relates to a machine and a method for metallization of three-dimensional objects of small sizes, such as scent bottles, stoppers or corks and the like, the characteristic sizes of which are in the order of few centimetres (2-10 cm), for example.

Metallization is a surface finishing work that is adapted to fully transform the surface of an article of manufacture making it of greater value and enhancing its aspect, in such a manner that a mere printed item takes a more sophisticated and precious appearance.

Metallization makes it possible to perfectly imitate other types of colours, those obtained by a galvanic bath process for example, thus enabling articles made of a "poor" material (be it plastic or metal material) to be considered aesthetically similar to more valuable articles (chromium- or gold-plated articles, for example).

In particular, the present invention refers to a metallization method involving the sputtering technique. This technique is carried out through ejection of atoms, ions or molecular fragments from a solid material, referred to as target, bombarded with a beam of energetic particles, generally a plasma of ions. The ion plasma hits the target that, due to collision, releases atoms and particles that will recondense on the surfaces of the object that is wished to be coated. The target consists of the material by which coating of the object will take place.

This process is made in a vacuum chamber. For correct implementation of the metallization process using the sputtering technique, the article of manufacture is required to be first painted with a primer for covering possible surface faults that could impair the metallization step to be carried out subsequently.

WO 00/28105 A1 discloses a vapour deposition apparatus for the semi-continuous treatment of a group of objects mounted on a carrier.

Obviously, the primer layer has to be perfectly dry before metallization of the article of manufacture is executed.

The machines and methods for metallization of three-dimensional objects of small sizes of the known art contemplate the presence of a spray painting station for depositing the primer on the articles of manufacture and a subsequent station for eliminating the solvent contained in the spray to enable drying of the primer.

Downstream of the solvent-eliminating station a metallization chamber is provided where the true metallization step is conducted.

In particular, a plurality of articles of manufacture is introduced into the metallization chamber and subsequently the vacuum is created inside the chamber to allow metallization of the articles of manufacture.

When transfer of the micrometric metal layer onto the articles of manufacture has been completed (the characteristic time for this operation being of a few seconds), the chamber is opened for extraction of the metallized articles.

These articles are sometimes further submitted to a painting process for being coated with a protective layer (or for further colouring operations).

In the methods and machines implementing the above described metallization methods, many articles of manufacture are required to be simultaneously introduced into the metallization chamber, in such a manner as to ensure a certain degree of efficiency and productivity of the plant.

In fact, against the few seconds that are necessary for the true sputtering process, the time required for creating the vacuum within the metallization chamber is of a few minutes, i.e. at least one order of magnitude higher than the sputtering time.

Taking into account the fact that a rather important amount of energy is required for depressurizing the metallization chamber, it is well apparent that the number of three-dimensional objects of small sizes to be simultaneously metallized must necessarily be high.

It results therefrom that it is impossible to modulate the production of metallized three-dimensional objects of small sizes as much as one likes.

In addition, the methods and machines implementing the prior art metallization methods described above are unable to operate in a continuous manner, because a continuous assistance is required by the operators entrusted with transfer of the batches of articles of manufacture between the different operating stations and in addition bulky and expensive storage spaces are necessary for the articles to be treated, those partly treated but not yet metallized, and those already metallized but still to be treated with a final finishing operation.

In this context, the technical task underlying the present invention is to propose a machine and a method for metallization of three-dimensional objects of small sizes overcoming the aforesaid drawbacks of the known art.

In particular, it is an aim of the present invention to propose a machine and a method for metallization of three-dimensional objects of small sizes carrying out finishing by means of a continuous process.

Another aim of the present invention is to propose a machine and a method for metallization of three-dimensional objects of small sizes that is fully automated.

It is a further aim of the present invention to propose a machine and a method for metallization of three-dimensional objects of small sizes having a good production flexibility.

The technical task mentioned and the aims specified are substantially achieved by a machine and a method for metallization of three-dimensional objects of small sizes comprising the technical features set out in one or more of the appended claims.

Further features and advantages of the present invention will become more apparent from the description given by way of non-limiting example of a preferred but not exclusive embodiment of a machine and a method for metallization of three-dimensional objects of small sizes, as illustrated in the accompanying drawings, in which:
- Fig. 1 is a top view of the machine according to the present invention;
- Fig. 2 is a side view of the machine seen in Fig. 1;

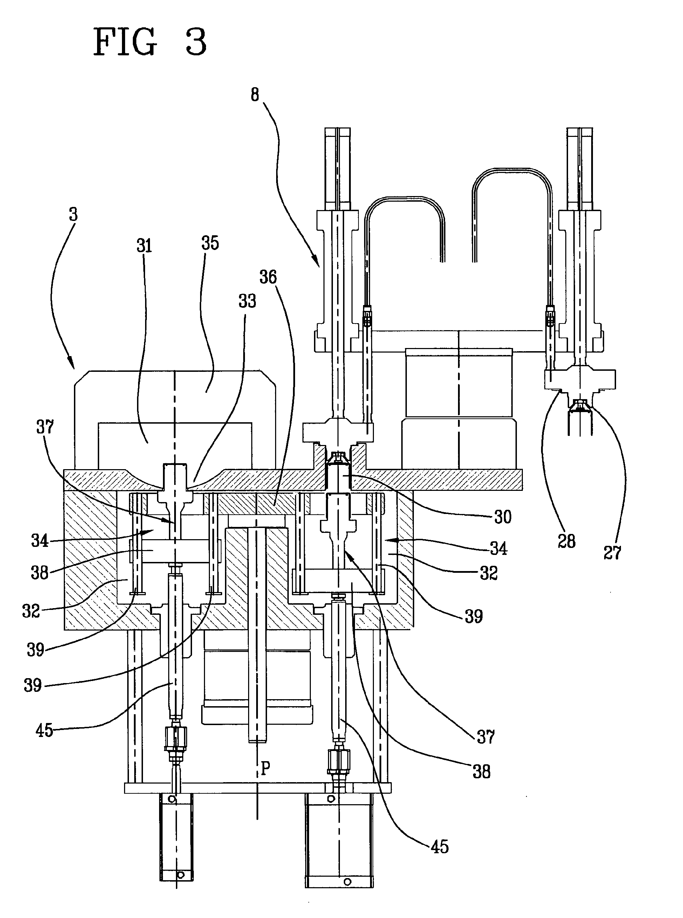

- Fig. 3 is a side view in section of a detail of the machine seen in Fig. 1.

With reference to the drawings, a machine for metallization of three-dimensional objects of small sizes, such as scent bottles, stoppers and the like the characteristic sizes of which are in the order of few centimetres (2-10 cm), according to the present invention, has been identified by reference numeral 1.

In the following specification reference will be explicitly made to plastic stoppers or corks as an example of the above mentioned objects.

It is to be noted that the same description is valid for any other object falling within the above definition, inclusive of objects made of metal material (such as aluminium).

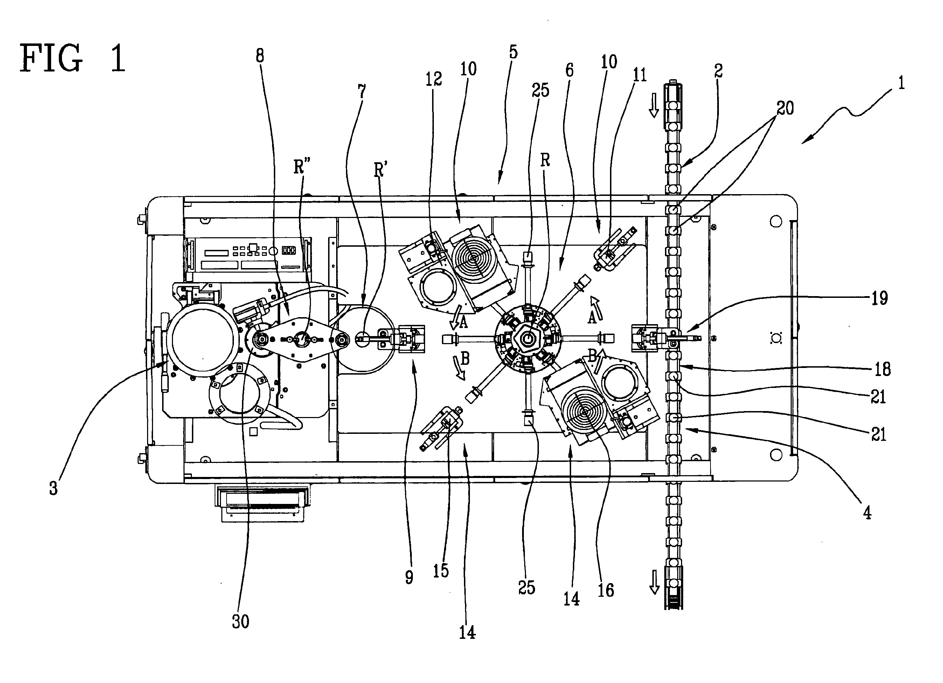

Referring to Fig. 1, the machine 1 comprises a feeding device 2 for supplying a sequence of stoppers to be metallized 20 disposed in a preferably continuous row.

The feeding device 2 comprises an actuating member 18 acting on the stoppers to be metallized 20. As shown, such an actuating member 18 is a linear conveyor and it can be, by way of example, a conveyor belt.

Stoppers to be metallized 20 are picked up by an actuating device 5 moving each stopper along the machine 1.

The machine 1 further comprises a metallizing device 3 carrying out metallization of the stopper to be metallized 20 using the sputtering technique. In greater detail, the metallizing device 3 comprises a main chamber 31 maintained to a constant forced vacuum condition in which the true metallization by the sputtering technique takes place.

A prechamber 32 is disposed upstream of the main chamber 31 and it is maintained to a constant forced vacuum condition too. The prechamber 32 is in fluid communication with the main chamber 31 through a passage port 33.

The prechamber 32 is in turn connected to a loading and unloading chamber 30 which is adapted to introduce the stoppers 20 to be metallized into the prechamber 32. In other words, the loading and unloading chamber 30 allows access to the prechamber 32.

The loading and unloading chamber 30 can be switched between a vacuum condition and an ambient-pressure condition to allow controlled introduction of each stopper into the main chamber 31 (through prechamber 32).

In other words, in the loading and unloading chamber 30 continuous pressurisation cycles are carried out, when the loading and unloading chamber 30 is in fluid communication with the external environment, and depressurisation cycles when the loading and unloading chamber 30 is in fluid communication with prechamber 32, in such a manner as to prepare stopper 20 to enter the main chamber 31 and also to prepare the just metallized stopper 21 to come out of the metallizing device 3.

Passage from the loading and unloading chamber 30 to the main chamber 31 takes place, as above said, through prechamber 32.

In this way, at each working cycle it is only necessary to depressurize the loading and unloading chamber 30 that has a much lower volume than the main sputtering chamber 31 and the prechamber 32, so that the energy required at each working cycle is minimised as well as the residence time of the stopper inside the metallizing device 3.

The residence time of each stopper inside the metallizing device 3 is of few seconds, i.e. 2-4 seconds.

The metallizing device 3 further comprises inner actuating means 34 disposed in the prechamber 32 for transferring each stopper 20 from the loading and unloading chamber 30 to the main chamber 31 and simultaneously bringing the metallized stopper 21 back from the main chamber 31 to close to the loading and unloading chamber 30.

In the described embodiment, the prechamber 32 is of a substantially toroidal shape. The metallizing device 3 comprises a holding body 35 defining the main chamber 31. The main chamber 31 is disposed on the side diametrically opposite to the loading and unloading chamber 30 relative to a symmetry axis of the prechamber 32.

The inner actuating means 34 comprises a carrousel device 36 rotating around an axis coincident with the symmetry axis of the loading and unloading chamber 32.

The carrousel device 36 comprises at least two grip members 37 diametrically opposite to each other for carrying each stopper 20 towards the main chamber 31 and each metallized stopper 21 towards the loading and unloading chamber 30, each on distinct paths. Each grip member 37 is movable along a respective circular trajectory.

In addition, each grip member 37 is movable along a direction parallel to the rotation axis of the carrousel device 36 to bring each stopper 20 from a first position in register with the loading and unloading chamber 30 and/or the passage port 33 to a distal lowered second position in which each stopper is subject to being moved.

Each grip member 37 comprises a receiving seat mounted on a respective carriage 38 slidable along guides 39 integral with a rotating portion of the carrousel device 36. Driving means 45 is associated with each carriage 38 for moving it in translation along the direction parallel to the rotation axis of the carrousel device 36. By way of example, this driving means 45 is hydraulic cylinders that can be activated on the grip members 37 when the latter have to be translated along said direction parallel to the rotation axis of the carrousel device 36.

In a preferred embodiment of the invention shown in the drawings, the machine 1 comprises a painting station 10 located upstream of the metallizing device 3 for treating stoppers 20 before metallization.

Each stopper to be metallized 20 passes through the painting station 10 where a paint, called primer, is applied for covering the faults on stopper 20.

The painting station 10 is located downstream of the feeding device 2.

The painting station 10 is of the airless type, i.e. of the type in which paint atomisation takes place by forcing the paint to pass through a nozzle 11 of reduced sizes at a very high pressure (of about 35 bars).

Thus air is not used for atomising the paint, and said paint is pressurised by a pump sucking the paint, pressurising it and then sending it to the nozzle that will carry out atomisation.

This type of painting enables paint overspray to be greatly reduced (thus limiting any waste of paint) and an excellent covering of the object to be obtained.

The primer application time on stopper 20 is of few seconds, i.e. 2-4 seconds.

Advantageously, the paint used does not contain solvents (or at all events the solvent therein contained is a minimal fraction) and it contains a photo-initiator that, submitted to electromagnetic radiation, gives rise to a chain reaction for paint crosslinking.

To this aim, downstream of the painting station 10 a UV ray dryer 12 is provided for submitting the paint to cross-linking.

It should be noted that exposure of the stopper to the UV rays is in the order of a few seconds (2-4 seconds).

The painting station 10 may comprise, in addition to the UV ray dryer 12, an infrared oven (not shown in the accompanying drawings) for elimination of the small fraction of solvent possibly still present in the paint.

It should be noted that exposure of the stopper to the UV rays is in the order of a few seconds (2-4 seconds).

The painting station 10, UV ray dryer 12 and infrared oven can not be present, in particular they are present when it is necessary to apply a primer film onto the object to be metallized.

In a preferred embodiment of the invention shown in the accompanying drawings, the machine 1 also comprises a painting station 14 adapted to lacquer the metallized stoppers 21, which is disposed downstream of the metallizing device 3.

In this painting station 14 a layer of protective paint is placed on each already finished stopper 21 to protect the metallic layer.

The painting station 14 is of the airless type, provided with a nozzle 15 of small sizes.

The paint or lacquer used does not contain solvents (or at all events the solvent therein contained is in a minimal fraction) and is a paint containing a photo-initiator that, submitted to electromagnetic radiation, gives rise to a chain reaction for paint crosslinking.

To this aim, downstream of the painting station 14 a UV ray dryer 16 is provided, to cause crosslinking of the paint.

Note that exposure of the stopper to the UV rays is in the order of a few seconds (2-4 seconds).

The painting station 14 may comprise, in addition to the UV ray dryer 16, an infrared oven (not shown in the drawings) for elimination of the possible small solvent fractions still present in the paint.

It should be noted that exposure of the stopper to the infrared rays is in the order of a few seconds (2-4 seconds).

The painting station 14, UV ray dryer 16 and infrared oven can not be present, in particular they are present when it is necessary to apply a final coating on the already metallized object.

Downstream of the painting station 14, if any, or downstream of the metallizing device 3, the metallized stoppers 21 are disposed on an unloading device 4 so as to provide a succession of metallized stoppers 21 disposed along a preferably continuous row that are conveyed out of the machine 1, preferably by the same actuating member 18 as used in the feeding device 2.

The actuating device 5 acts along each of the described operating stations to move the stoppers to be metallized 20 and the metallized stoppers 21 respectively, one at a time, in succession along the whole machine 1.

In detail, the actuating device 5 comprises a carrousel conveyor 6 operatively active between the feeding device 2 and the metallizing device 3.

The carrousel conveyor 6 carries each stopper to be metallized 20, one at a time, from the feeding device 2 to the metallizing device 3 along a first path A.

In addition, the same carrousel conveyor 6 is operatively active between the metallizing device 3 and the unloading device 4 so as to carry each metallized stopper 21, one at a time, from the metallizing device 3 to the unloading device 4 along a second path B that is distinct from the first path A.

It should be noted that advantageously the step of moving stoppers 20 from the feeding device 2 to the metallizing device 3 is carried out simultaneously with the step of transferring stoppers 21 from the metallizing device 3 to the unloading device 4. In addition, both said steps are executed by the same carrousel conveyor 6.

As shown in Fig. 1, the carrousel conveyor 6 comprises a plurality of grip seats 25 spaced apart the same distance and opposite two by two relative to a rotation axis R of the carrousel conveyor 6.

During operation of the machine 1, each grip seat 25 receives a single stopper to be metallized 20 from the feeding device 2 and transfers it along the first path A to the metallizing device 3. The portion of the first path defined by this grip seat 25 is in the shape of a semi-circumference.

When the stopper to be metallized 20 is delivered to the metallizing device 3, the corresponding grip seat 25 is occupied by a metallized stopper 21 coming from the metallizing device 3. Each grip seat 25 travels along the second path B towards the unloading device 4. This portion too of the second path B is in the shape of a semi-circumference.

It will be recognised that while each grip seat 25 travels along the first path A, the corresponding grip seat 25 that is diametrically opposite relative to the rotation axis R will travel along the second path B.

Still with reference to Fig. 1, the carrousel conveyor 6 is also active on the painting device 10 along the first path A.

Operatively interposed between the carrousel conveyor 6 and the metallizing device 3 is a transfer conveyor 7 and an overturning device 9. In greater detail, the overturning device 9 is disposed between the carrousel conveyor 6 and the transfer conveyor 7.

The transfer conveyor 7 is of the rotary type and in particular it rotates around its own rotation axis R', disposed parallel to the rotation axis R of the carrousel conveyor 6.

In the same manner as specified for the carrousel conveyor 6, the transfer conveyor 7 comprises two grip seats 26 of its own that are opposite relative to the rotation axis R' of the transfer conveyor 7. Said grip seats 26 are simultaneously occupied by a stopper to be metallized that is movable towards the metallizing device 3, and a metallized stopper 21 that is movable towards the carrousel conveyor 6, respectively.

In other words, while one of the grip seats 26 of the transfer conveyor 7 travels along a portion of the first path A, the other grip seat 26 of the transfer conveyor 7 is travelling along a portion of the second path B. Both said portions of the first A and second B paths are of semi-circular shape.

The overturning device 9, located between the carrousel conveyor 6 and the transfer conveyor 7, carries out transfer of the stoppers to be metallized 20 and the metallized stoppers 21 between said conveyors.

Moreover the overturning device 9 during said transferring phases changes the tilt of the stoppers.

In fact, it should be noted that when both the stoppers to be metallized 20 and the metallized stoppers 21 are on the carrousel conveyor 6, they lie with an extension axis T thereof orthogonal to the rotation axis R of the carrousel conveyor 6 itself. On the contrary, when both the stoppers to be metallized 20 and the metallized stoppers 21 are on the transfer conveyor 7, they lie with their extension axis T parallel to the rotation axis R' of the transfer conveyor 7 itself.

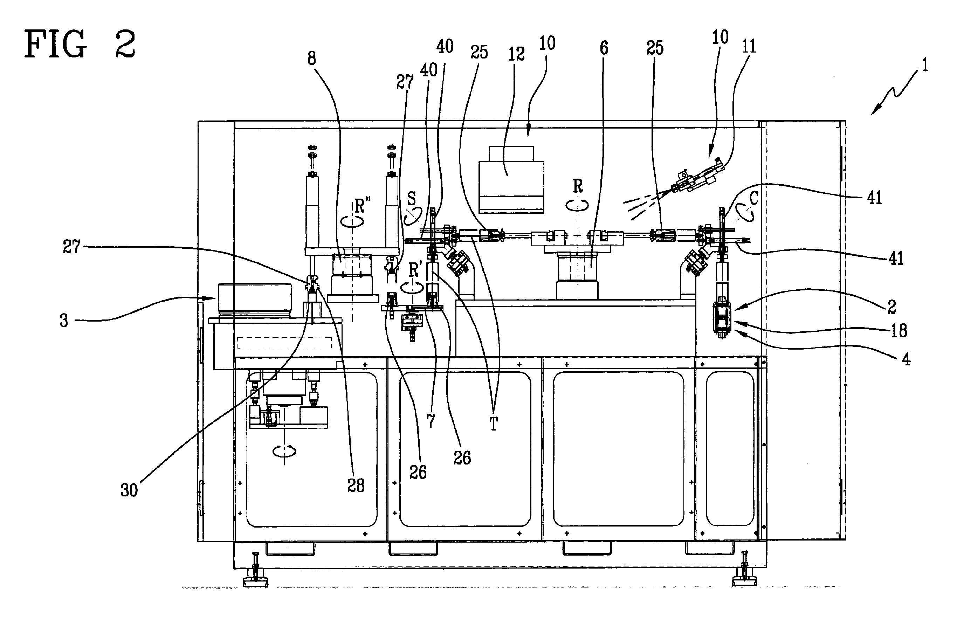

In this regard, the overturning device 9 comprises at least two gripping arms 40 integral with each other and inclined. As shown in particular in Fig. 2, the gripping arms 40 are substantially perpendicular to each other.

The overturning device 9 can rotate along a bisecting axis S relative to the two gripping arms 40.

As shown, the bisecting axis S is substantially disposed at 45° relative to a reference vertical axis. In detail, the bisecting axis S is substantially disposed at 45° relative to the rotation axis R of the carrousel conveyor 6 or the rotation axis R' of the transfer conveyor 7.

One of the gripping arms 40 carries the stoppers to be metallized 20 from the carrousel conveyor 6 to the transfer conveyor 7 performing a 180° rotation and travelling over a portion of the first path A, while simultaneously the other gripping arm 40 is carrying the metallized stoppers 21, one at a time in succession, from the transfer conveyor 7 to the carrousel conveyor 6 performing a 180° rotation and travelling over a portion of the second path B.

In addition, the actuating device 5 comprises an introduction/extraction device 8 to introduce and extract each stopper to be metallized 20 and each metallized stopper 21 respectively, into and from the metallizing device 3.

The introduction/extraction device 8 is operatively placed between the transfer conveyor 7 and the metallizing device 2. In other words, the introduction/extraction device 8 introduces a stopper to be metallized 20 into the metallization device 3 and simultaneously removes a metallized stopper 21 therefrom.

The introduction/extraction device 8 consists of a conveyor rotating around a rotation axis R" thereof. The introduction/extraction device 8 comprises at least two grip seats 27 that are diametrically opposite relative to the rotation axis R". Each grip seat 27 is respectively occupied by a stopper to be metallized 20 entering the metallizing device 3 along a stretch of the first path A and by a metallized stopper 21 coming out of the metallizing device 3 along a stretch of the second path B.

Each grip seat 27 of the introduction/extraction device 8 is movable not only along circular paths, but also along a direction substantially parallel to the rotation axis R" of said introduction/extraction device 8. In detail, each grip seat 27 is movable between a first position that is raised relative to the loading and unloading chamber 30 of the metallizing device 3 and a second position (that is to a lower location relative to the first one) in which it is at the same height as the loading and unloading chamber 30.

In particular, the first distal position is occupied by the grip seats 27 during rotation of the introduction/extraction device 8, and therefore during the travel along the first A and second paths B.

The second position is occupied when each grip seat 27 of the introduction/extraction device 8 is in register with one of the grip seats 26 of the transfer conveyor 7 to receive a stopper to be metallized 20 and deliver a metallized stopper 21.

In addition, this second position is taken when each grip seat 27 of the introduction/extraction device 8 is in register with the loading and unloading chamber 30 of the metallizing device 3.

Advantageously, each grip seat 27 of the introduction/extraction device 8 comprises a sealing member 28 sealing the loading and unloading chamber 30 of the metallizing device 3 when the grip seat 27 occupies its second position at the loading and unloading chamber 30.

The actuating device 5 further comprises a picking up/depositing device 19 acting at least between the feeding device 2 and the carrousel conveyor 6 to transfer each stopper to be metallized 20 exactly from the feeding device 2 to the carrousel conveyor 6.

In addition, the picking up/depositing device 19 acts between the carrousel conveyor 6 and the unloading device 4 for transferring each metallized stopper 21 from the carrousel conveyor 6 to the unloading device 4.

The picking up/depositing device 19 is quite similar to the overturning device 9.

In this regard, the picking up/depositing device 19 comprises at least two hooking arms 41 integral with each other and inclined. As illustrated in particular in Fig. 2, the hooking arms 41 are substantially perpendicular to each other.

The picking up/depositing device 19 can rotate along a bisecting axis C relative to the two hooking arms 41.

As shown, the bisecting axis C is substantially disposed at 45° relative to a reference vertical axis. In detail, the bisecting axis C is substantially disposed at 45° relative to the rotation axis R of the carrousel conveyor 6.

During operation, one of the hooking arms 41 moves the stoppers to be metallized 20 from the feeding device 2 to the carrousel conveyor 6, through a 180° rotation, while simultaneously the other hooking arm 41 moves the metallized stoppers 21 in succession, one at a time, from the carrousel conveyor 6 to the unloading device, through a 180° rotation.

In the same manner as described with reference to the overturning device 9, the picking up/depositing device 19 too modifies the inclination of the stoppers during the aforesaid transport steps.

The invention as described reaches the intended purposes and achieves the previously stated important advantages.

The machine for metallization of three-dimensional objects of small sizes is fully automated, because the combined effect of the feeding device 2, the airless painting station, the metallizing device provided with the loading and unloading chamber 30, and the unloading device 4, does not require the direct intervention of operators during ordinary operation of the machine.

In addition, since the machine 1 acts on one stopper at a time in a continuous manner, a good production flexibility can be obtained, i.e. it is possible to produce the exact amount of metallized objects required each time.

## Claims

1. A machine for metallization of three-dimensional objects of small sizes, comprising:
- a feeding device (2) to supply a succession of objects to be metallized (20);
- a metallizing device (3) comprising a main sputtering chamber (31) in a condition of permanent vacuum for coating each object (20) with a predetermined metallic layer, and a loading and unloading chamber (30) for a single object that can be switched between a vacuum condition and an ambient-pressure condition and is operatively associated with said main chamber (31);
- an unloading device (4) for the succession of metallized objects (21), which is operatively placed downstream of the metallizing device (3);
- a painting station (10, 14) of the airless type and operatively disposed downstream of the feeding device (2) and upstream of the unloading device (4).

2. A machine as claimed in claim 1, **characterised in that** it further comprises a carrousel conveyor (6), operatively acting at least between the feeding device (2) and the metallizing device (3) for carrying each object to be metallized (20), one at a time, from the feeding device (2) to the metallizing device (3) along a first path (A); said carrousel conveyor (6) being further operatively active between the metallizing device (3) and the unloading device (4) for carrying each metallized object (21), one at a time, from the metallizing device (3) to the unloading device (4) along a second path (B) distinct from said first path (A).

3. A machine as claimed in claim 2, **characterised in that** it further comprises a transfer conveyor (7) rotating and acting between said carrousel conveyor (6) and metallizing device (3) for carrying each object to be metallized (20) from the carrousel conveyor (6) to the metallizing device (3) and carrying each metallized object (21) from the metallizing device (3) to the carrousel conveyor (6).

4. A machine as claimed in claim 2, **characterised in that** said carrousel conveyor (6) comprises at least two grip seats (25) positioned opposite to each other relative to a rotation axis (R) of said carrousel conveyor (6), said seats (25) being alternately movable along the first (A) and the second (B) paths for transport of an object to be metallized (20) and a metallized object (21), respectively.

5. A machine as claimed in claim 4, **characterised in that** it further comprises an overturning device (9) operatively interposed between the carrousel conveyor (6) and the transfer conveyor (7) and simultaneously acting on an object to be metallized (20) for carrying it from said carrousel conveyor (6) to said transfer conveyor (7) and on a metallized object (21) for carrying it from said transfer conveyor (7) to said carrousel conveyor (6), so as to modify the orientation of each object (20, 21) relative to the rotation axis (R).

6. A machine as claimed in claim 5, **characterised in that** the overturning device (9) comprises at least two gripping arms (40) inclined to each other and rotating about a bisecting axis (S) relative to the two gripping arms (40), each gripping arm (40) being alternately active on a grip seat (25) of said carrousel conveyor (6) and a grip seat (26) of said transfer conveyor (7).

7. A machine as claimed in anyone of the preceding claims, **characterised in that** it further comprises an introduction/extraction device (8) for each object (20, 21) into and from the loading and unloading chamber (30) of the metallizing device (3), having grip seats (27) of its own that are movable along a direction substantially parallel to the rotation axis (R) of said introduction/extraction device (8) between a first raised position relative to the loading and unloading chamber (30) and a second position in which they are disposed at the same height as the loading and unloading chamber (30).

8. A machine as claimed in claim 7, **characterised in that** each grip seat (27) of said introduction/extraction device (8) comprises a sealing member (28) acting on the loading and unloading chamber (30) when said grip seat (27) takes up the second position in register with the loading and unloading chamber (30).

9. A machine as claimed in anyone of the preceding claims, **characterised in that** said painting station (10) of the airless type is placed upstream of the metallizing device (3) for laying a film of primer on the object to be metallized; a UV ray dryer (12) being placed immediately downstream of the painting station (10) for fixing the primer film onto the object to be metallized.

10. A machine as claimed in claim 9, wherein said painting station (10) comprises an infrared oven for eliminating the possible solvent fraction present in the paint.

11. A machine as claimed in anyone of the preceding claims, **characterised in that** said painting station (14) of the airless type is placed downstream of the metallization device (3) for lacquering the metallized object; a UV ray dryer (16) being located immediately downstream of the painting station (14) for fixing the lacquer onto the metallized object.

12. A machine as claimed in claim 11, wherein said painting station (14) comprises an infrared oven for eliminating the possible solvent fraction present in the paint.

13. A method for metallization of three-dimensional objects of small sizes, comprising the steps of:
- providing an orderly succession of objects to be metallized (20) at a feeding device (2) and feed them in a row to a metallizing device (3);
- introducing a single object to be metallized into a loading and unloading chamber (30) of a metallizing device (3);
- pressurising the loading and unloading chamber (30) and introducing the object to be metallized into a main sputtering chamber (31) of the metallizing device;
- introducing the metallized object into the loading and unloading chamber (30) and depressurizing the same;
- picking up the metallized object (21) from the metallizing device (3) and providing a succession of metallized object (21) at an unloading device;
- painting the objects (20, 21) between the feeding station (2) and unloading station (4), using a painting device (10) of the airless type.

14. A method as claimed in claim 13, further comprising the step of conveying said objects to be metallized (20), one at a time, in succession from said feeding device (2) to said metallizing device (3) along a first path (A), and the step of conveying said metallized objects (21), one at a time, in succession from said metallizing device (3) to said unloading device (4) along a second path (B) distinct from the first path (A).

15. A method as claimed in claim 14, **characterised in that** the step of conveying said objects to be metallized (20), one at a time, in succession from said feeding device (2) to said metallizing device (3) is simultaneous with the step of conveying said metallized objects (21), one at a time, in succession from said metallizing device (3) to said unloading device (4).

## Patentansprüche

1. Vorrichtung zum Metallisieren dreidimensionaler kleinstückiger Gegenstände, umfassend:
- eine Zuführeinrichtung (2) zum Zuleiten einer Aufeinanderfolge von zu metallisierenden Gegenständen (20);
- eine Metallisierungseinrichtung (3), umfassend eine Hauptsputterkammer (31) in einem Zustand des permanenten Vakuums zum Beschichten eines jeden Gegenstandes (20) mit einer festgelegten Metallschicht, und eine Be- und Entladekammer (30) für einen einzigen Gegenstand, die zwischen einem Vakuumzustand und einem Umgebungsdruckzustand umgeschaltet werden kann und mit der Hauptkammer (31) wirkverbunden ist;
- eine Entladeeinrichtung (4) für die Aufeinanderfolge metallisierter Gegenstände (21), die der Metallisierungseinrichtung (3) nachgelagert wirkend platziert ist;
- eine Lackierstation (10, 14) des Airless-Typs, die der Zuführeinrichtung (2) nachgelagert und der Entladeeinrichtung (4) vorgelagert wirkend angeordnet ist.

2. Vorrichtung nach Anspruch 1, **dadurch gekennzeichnet, dass** sie ferner einen Karussellförderer (6) umfasst, der mindestens zwischen der Zuführeinrichtung (2) und der Metallisierungseinrichtung (3) wirkend agiert, um jeden zu metallisierenden Gegenstand (20) nacheinander von der Zuführeinrichtung (2) zur Metallisierungseinrichtung (3) entlang einer ersten Bahn (A) zu führen; wobei der Karussellförderer (6) ferner zwischen der Metallisierungseinrichtung (3) und der Entladeeinrichtung (4) wirkend aktiv ist, um jeden metallisierten Gegenstand (21) nacheinander von der Metallisierungseinrichtung (3) zur Entladeeinrichtung (4) entlang einer zweiten Bahn (B) zu führen, die sich von der ersten Bahn (A) unterscheidet.

3. Vorrichtung nach Anspruch 2, **dadurch gekennzeichnet, dass** sie ferner einen Übertragungsförderer (7) umfasst, der zwischen dem Karussellförderer (6) und der Metallisierungseinrichtung (3) rotiert und agiert, um jeden zu metallisierenden Gegenstand (20) vom Karussellförderer (6) zur Metallisierungseinrichtung (3) zu führen und jeden metallisierten Gegenstand (21) von der Metallisierungseinrichtung (3) zum Karussellförderer (6) zu führen.

4. Vorrichtung nach Anspruch 2, **dadurch gekennzeichnet, dass** der Karussellförderer (6) mindestens zwei Greifsitze (25) umfasst, die relativ zu einer Rotationsachse (R) des Karussellförderers (6) einander gegenüber positioniert sind, wobei die Sitze (25) alternierend entlang der ersten (A) und der zweiten (B) Bahn zum Transport eines zu metallisierenden Gegenstandes (20) beziehungsweise metallisierten Gegenstandes (21) beweglich sind.

5. Vorrichtung nach Anspruch 4, **dadurch gekennzeichnet, dass** sie ferner eine Umkippeinrichtung (9) umfasst, die wirkend zwischen dem Karussellförderer (6) und dem Übertragungsförderer (7) liegt und simultan auf einen zu metallisierenden Gegenstand (20) einwirkt, um ihn vom Karussellförderer (6) zum Übertragungsförderer (7) zu führen und auf einen metallisierten Gegenstand (21), um ihn vom Übertragungsförderer (7) zum Karussellförderer (6) zu führen, sodass die Orientierung eines jeden Gegenstandes (20, 21) relativ zur Rotationsachse (R) geändert wird.

6. Vorrichtung nach Anspruch 5, **dadurch gekennzeichnet, dass** die Umkippeinrichtung (9) mindestens zwei Greifarme (40) umfasst, die geneigt zueinander sind und um eine winkelhalbierende Achse (S) relativ zu den zwei Greifarmen (40) rotieren, wobei jeder Greifarm (40) alternierend auf einem Greifsitz (25) des Karussellförderers (6) und einem Greifsitz (26) des Übertragungsförderers (7) aktiv ist.

7. Vorrichtung nach einem der vorangehenden Ansprüche, **dadurch gekennzeichnet, dass** sie ferner eine Einrichtung (8) zum Einführen und zur Herausnahme eines jeden Gegenstandes (20, 21) in die und aus der Be- und Entladekammer (30) der Metallisierungseinrichtung (3) umfasst, aufweisend eigene Greifsitze (27), die entlang einer Richtung, die im Wesentlichen parallel zur Rotationsachse (R) der Einführ-/Herausnahmeeinrichtung (8) ist, zwischen einer relativ zur Be- und Entladekammer (3) ersten angehobenen Position und einer zweiten Position, in der sie in derselben Höhe wie die Be- und Entladekammer (30) angeordnet sind, beweglich sind.

8. Vorrichtung nach Anspruch 7, **dadurch gekennzeichnet, dass** jeder Greifsitz (27) der Einführ-/Herausnahmeeinrichtung (8) ein Versiegelungsglied (28) umfasst, das auf die Be- und Entladekammer (30) einwirkt, wenn der Greifsitz (27) die zweite Position deckungsgleich mit der Be- und Entladekammer (30) einnimmt.

9. Vorrichtung nach einem der vorangehenden Ansprüche, **dadurch gekennzeichnet, dass** die Lackierstation (10) des Airless-Typs der Metallisierungseinrichtung (3) vorgelagert platziert ist, um einen Grundierungsfilm auf den zu metallisierenden Gegenstand aufzutragen; wobei ein UV-Strahlentrockner (12) der Lackierstation (10) unmittelbar nachgelagert platziert ist, um den Grundierungsfilm auf dem zu metallisierenden Gegenstand zu fixieren.

10. Vorrichtung nach Anspruch 9, wobei die Lackierstation (10) einen Infrarotofen zum Entfernen von möglichen Lösungsmittelfraktionen im Lack umfasst.

11. Vorrichtung nach einem der vorangehenden Ansprüche, **dadurch gekennzeichnet, dass** die Lackierstation (14) des Airless-Typs der Metallisierungseinrichtung (3) nachgelagert platziert ist, um den metallisierten Gegenstand zu lackieren; wobei ein UV-Strahlentrockner (16) der Lackierstation (14) unmittelbar nachgelagert platziert ist, um die Lackfarbe auf dem metallisierten Gegenstand zu fixieren.

12. Vorrichtung nach Anspruch 11, wobei die Lackierstation (14) einen Infrarotofen zum Entfernen von möglichen Lösungsmittelfraktionen im Lack umfasst.

13. Verfahren zum Metallisieren dreidimensionaler kleinstückiger Gegenstände, umfassend die folgenden Schritte:
- Bereitstellen einer geordneten Aufeinanderfolge von zu metallisierenden Gegenständen (20) an einer Zuführeinrichtung (2) und Zuführen von diesen in einer Reihe zu einer Metallisierungseinrichtung (3);
- Einführen eines einzelnen zu metallisierenden Gegenstandes in eine Be- und Entladekammer (30) einer Metallisierungseinrichtung (3);
- Druckbeaufschlagung der Be- und Entladekammer (30) und Einführen des zu metallisierenden Gegenstandes in eine Hauptsputterkammer (31) der Metallisierungseinrichtung;
- Einführen des metallisierten Gegenstandes in die Be- und Entladekammer (30) und Druckentlastung von dieser;
- Aufnahme des metallisierten Gegenstandes (21) aus der Metallisierungseinrichtung (3) und Bereitstellung einer Aufeinanderfolge metallisierter Gegenstände (21) an einer Entladungseinrichtung;
- Lackieren der Gegenstände (20, 21) zwischen der Zuführstation (2) und Entladestation (4) unter Verwendung einer Lackiereinrichtung (10) des Airless-Typs.

14. Verfahren nach Anspruch 13, ferner umfassend den Schritt des Beförderns der zu metallisierenden Gegenstände (20) nacheinander, in Aufeinanderfolge, von der Zuführeinrichtung (2) zur Metallisierungseinrichtung (3) entlang einer ersten Bahn (A) und den Schritt des Beförderns der metallisierten Gegenstände (21) nacheinander, in Aufeinanderfolge, von der Metallisierungseinrichtung (3) zur Entladeeinrichtung (4) entlang einer zweiten Bahn (B), die sich von der ersten Bahn (A) unterscheidet.

15. Verfahren nach Anspruch 14, **dadurch gekennzeichnet, dass** der Schritt des Beförderns der zu metallisierenden Gegenstände (20) nacheinander, in Aufeinanderfolge, von der Zuführeinrichtung (2) zur Metallisierungseinrichtung (3) gleichzeitig zum Schritt des Beförderns der metallisierten Gegenstände (21) nacheinander, in Aufeinanderfolge, von der Metallisierungseinrichtung (3) zur Entladeeinrichtung (4) erfolgt.

## Revendications

1. Dispositif pour la métallisation de pièces tridimensionnelles de petite taille, comprenant :
- un dispositif d'alimentation (2) pour fournir une succession de pièces à métalliser (20) ;
- un dispositif métalliseur (3) comprenant une chambre de pulvérisation (31) principale dans une condition de vide permanent pour enduire chaque pièce (20) avec une couche de métal prédéterminée, ainsi qu'une chambre de chargement et de déchargement (30) pour une seule pièce pouvant passer d'une condition de vide à une condition de pression ambiante et étant fonctionnellement associée à ladite chambre principale (31) ;
- un dispositif de déchargement (4) de la succession de pièces métallisées (21), étant fonctionnellement placé en aval du dispositif métalliseur (3) ;
- une station de peinture (10, 14) airless et fonctionnellement disposée en aval du dispositif d'alimentation (2) et en amont du dispositif de déchargement (4).

2. Dispositif selon la revendication 1, **caractérisé en ce qu'**il comprend de plus un convoyeur carrousel (6), agissant de façon fonctionnelle au moins entre le dispositif d'alimentation (2) et le dispositif métalliseur (3) pour acheminer, l'une après l'autre, chaque pièce à métalliser (20) du dispositif d'alimentation (2) au dispositif métalliseur (3) le long d'un premier parcours (A) ; ledit convoyeur carrousel (6) étant de plus fonctionnellement actif entre le dispositif métalliseur (3) et le dispositif de déchargement (4) pour acheminer, l'une après l'autre, chaque pièce métallisée (21) du dispositif métalliseur (3) au dispositif de déchargement (4) le long d'un second parcours (B) distinct dudit premier parcours (A).

3. Dispositif selon la revendication 2, **caractérisé en ce qu'**il comprend de plus un transbordeur (7) en rotation et agissant entre ledit convoyeur carrousel (6) et le dispositif métalliseur (3) pour acheminer chaque pièce à métalliser (20) du convoyeur carrousel (6) au dispositif métalliseur (3) et pour acheminer chaque pièce métallisée (21) du dispositif métalliseur (3) au convoyeur carrousel (6).

4. Dispositif selon la revendication 2, **caractérisé en ce que** ledit convoyeur carrousel (6) comprend au moins deux sièges de préhension (25) positionnés de façon opposée l'un à l'autre par rapport à un axe de rotation (R) dudit convoyeur carrousel (6), lesdits sièges (25) étant alternativement mobiles le long des premier (A) et second (B) parcours pour transporter, respectivement, une pièce à métalliser (20) et une pièce métallisée (21).

5. Dispositif selon la revendication 4, **caractérisé en ce qu'**il comprend de plus un dispositif de retournement (9) fonctionnellement interposé entre le convoyeur carrousel (6) et le transbordeur (7) et agissant simultanément sur une pièce à métalliser (20), pour l'acheminer dudit convoyeur carrousel (6) au dit transbordeur (7), et sur une pièce métallisée (21) pour l'acheminer dudit transbordeur (7) au dit convoyeur carrousel (6), de sorte à modifier l'orientation de chaque pièce (20, 21) par rapport à l'axe de rotation (R).

6. Dispositif selon la revendication 5, **caractérisé en ce que** le dispositif de retournement (9) comprend au moins deux bras de préhension (40) inclinés l'un par rapport à l'autre et tournant autour d'un axe bissecteur (S) par rapport aux deux bras de préhension (40), chaque bras de préhension (40) étant alternativement actif sur un siège de préhension (25) dudit convoyeur carrousel (6) et un siège de préhension (26) dudit transbordeur (7).

7. Dispositif selon l'une quelconque des revendications précédentes, **caractérisé en ce qu'**il comprend de plus un dispositif d'introduction/d'extraction (8) pour chaque pièce (20, 21) vers et depuis la chambre de chargement et de déchargement (30) du dispositif métalliseur (3), ayant ses propres sièges de préhension (27) étant mobiles le long d'une direction substantiellement parallèle à l'axe de rotation (R) dudit dispositif d'introduction/d'extraction (8) entre une première position haute par rapport à la chambre de chargement et de déchargement (30) et une seconde position dans laquelle les sièges sont disposés à la même hauteur que la chambre de chargement et de déchargement (30).

8. Dispositif selon la revendication 7, **caractérisé en ce que** chaque siège de préhension (27) dudit dispositif d'introduction/d'extraction (8) comprend un élément d'étanchéité (28) agissant sur la chambre de chargement et de déchargement (30) lorsque ledit siège de préhension (27) adopte la seconde position coïncidant avec la chambre de chargement et de déchargement (30).

9. Dispositif selon l'une quelconque des revendications précédentes, **caractérisé en ce que** ladite station de peinture (10) airless est placée en amont du dispositif métalliseur (3) pour poser un film primaire sur la pièce à métalliser ; un séchoir à rayons ultraviolets (12) étant placé immédiatement en aval de la station de peinture (10) pour fixer le film primaire sur la pièce à métalliser.

10. Dispositif selon la revendication 9, dans lequel ladite station de peinture (10) comprend un four à infrarouges afin d'éliminer la possible fraction de solvant présente dans la peinture.

11. Dispositif selon l'une quelconque des revendications précédentes, **caractérisé en ce que** ladite station de peinture (14) airless est placée en aval du dispositif métalliseur (3) pour effectuer le laquage de la pièce métallisée ; un séchoir à rayons ultraviolets (16) étant situé immédiatement en aval de la station de peinture (14) pour fixer la laque sur la pièce métallisée.

12. Dispositif selon la revendication 11, dans lequel ladite station de peinture (14) comprend un four à infrarouges afin d'éliminer la possible fraction de solvant présente dans la peinture.

13. Procédé pour la métallisation de pièces tridimensionnelles de petite taille, comprenant les étapes de :
- prévoir une succession ordonnée de pièces à métalliser (20) au niveau d'un dispositif d'alimentation (2) et les acheminer en une rangée vers un dispositif métalliseur (3) ;
- introduire une seule pièce à métalliser dans une chambre de chargement et de déchargement (30) d'un dispositif métalliseur (3) ;
- mettre sous pression la chambre de chargement et de déchargement (30) et introduire la pièce à métalliser dans une chambre de pulvérisation (31) principale du dispositif métalliseur ;
- introduire la pièce métallisée dans la chambre de chargement et de déchargement (30) et mettre sous pression cette dernière ;
- recueillir la pièce métallisée (21) du dispositif métalliseur (3) et prévoir une succession de pièces métallisées (21) au niveau d'un dispositif de déchargement ;
- peindre les pièces (20, 21) entre le poste d'alimentation (2) et le poste de déchargement (4), en utilisant un dispositif de peinture (10) airless.

14. Procédé selon la revendication 13, comprenant de plus l'étape d'acheminement desdites pièces à métalliser (20), une par une successivement, dudit dispositif d'alimentation (2) au dit dispositif métalliseur (3) le long d'un premier parcours (A), ainsi que l'étape d'acheminement desdites pièces métallisées (21), une par une successivement, dudit dispositif métalliseur (3) vers ledit dispositif de déchargement (4) le long d'un second parcours (B) distinct du premier parcours (A).

15. Procédé selon la revendication 14, **caractérisé en ce que** l'étape d'acheminement desdites pièces à métalliser (20), une par une successivement, dudit dispositif d'alimentation (2) au dit dispositif métalliseur (3) se déroule simultanément à l'étape d'acheminement desdites pièces métallisées (21), une par une successivement, dudit dispositif métalliseur (3) vers ledit dispositif de déchargement (4).
